# EUROPEAN PATENT APPLICATION

(11) **EP 4 727 012 A1**
(43) Date of publication of application: **15.04.2026**
(21) Application number: 25196334.4
(22) Date of filing: 18.08.2025
(51) Int. Cl.: H03K 3/356

(54) **VOLTAGE LEVEL SHIFTER**

(30) Priority: 08.10.2024 TW 113138311
(71) Applicant: Winbond Electronics Corp., Taichung City, Taiwan. (TW)
(72) Inventor: CHEN, Chung-Zen, Taichung City (TW)
(74) Representative: Becker, Eberhard

(57) **Abstract**

A voltage level shifter (100, 200, 400) is provided. The voltage level shifter (100, 200, 400) includes a voltage level shift circuit (110, 210, 410) and a boost circuit (120, 220, 420). The voltage level shift circuit (110, 210, 410) operates between a first voltage (VH) and a second voltage (VSS). The voltage level shift circuit (110, 210, 410) includes a pair of cross-coupled transistors (111, 211, 411) and a pair of differential transistors (112, 212, 412). The pair of differential transistors (112, 212, 412) is coupled to the pair of cross-coupled transistors (111, 211, 411) and receives a pair of input signals. The boost circuit (120, 220, 420) is coupled to the voltage level shift circuit (110, 210, 410). The boost circuit (120, 220, 420) executes a pre-charging operation on boost input terminals of the pair of cross-coupled transistors (111, 211, 411), generates a voltage pulse (PS) based on a charge pump operation according to a control pulse signal (CS, PD), and provides the voltage pulse (PS) to the boost input terminals. The control pulse signal (CS, PD) is generated corresponding to a transient edge of the pair of input signals.

## Description

### BACKGROUND

### Technical Field

The disclosure relates to an electronic circuit, and in particular to a voltage level shifter.

### Description of Related Art

Generally speaking, voltage level shifters of electronic products may be designed according to respective requirements, and various functions are implemented through switching the voltage level shifters between target working voltage ranges. For example, a memory device includes a voltage level shifter, and a shift operation between different voltage values is performed through the voltage level shifter.

However, in an application where a voltage value of a supply voltage is low (for example, below 1.8 volts) (for example, an energy-saving application), a voltage shift operation cannot be effectively completed due to the fierce voltage fighting on an output terminal of a conventional voltage level shifter. In this way, the conventional voltage level shifter is not conducive to implementation in the energy-saving application and consumes too much power, thereby reducing the speed of signal transition.

### SUMMARY

An embodiment of the disclosure provides a voltage level shifter, which can reduce voltage fighting, thereby increasing the speed of signal transition.

A voltage level shifter of the embodiment of the disclosure includes a voltage level shift circuit and a boost circuit. The voltage level shift circuit operates between a first voltage and a second voltage. The voltage level shift circuit includes a pair of cross-coupled transistors and a pair of differential transistors. The pair of differential transistors is coupled to the pair of cross-coupled transistors and receives a pair of input signals. The boost circuit is coupled to the voltage level shift circuit. The boost circuit is configured to execute a pre-charging operation on multiple boost input terminals of the pair of cross-coupled transistors, generate at least one voltage pulse based on a charge pump operation according to at least one control pulse signal, and provide the voltage pulse to the boost input terminals. The control pulse signal is generated corresponding to a transient edge of the pair of input signals.

Based on the above, the voltage level shifter of the embodiment of the disclosure executes the pre-charging operation on the boost input terminals through the boost circuit, which can increase voltage values on the input terminals to reduce voltage fighting. The voltage level shifter also provides the voltage pulse to the boost input terminals based on the charge pump operation through the boost circuit, which can protect the voltage level shift circuit for implementation in an energy-saving application, and can further reduce voltage fighting, thereby accelerating the speed of signal transition.

### BRIEF DESCRIPTION OF THE DRAWINGS

FIG. 1 is a block diagram of a voltage level shifter according to an embodiment of the disclosure.
FIG. 2 is a circuit diagram of a voltage level shifter according to an embodiment of the disclosure.
FIG. 3 is a schematic diagram of an operation of the voltage level shifter according to the embodiment of FIG. 2 of the disclosure.
FIG. 4 is a circuit diagram of a voltage level shifter according to another embodiment of the disclosure.
FIG. 5 is a schematic diagram of an operation of the voltage level shifter according to the embodiment of FIG. 4 of the disclosure.

### DESCRIPTION OF THE EMBODIMENTS

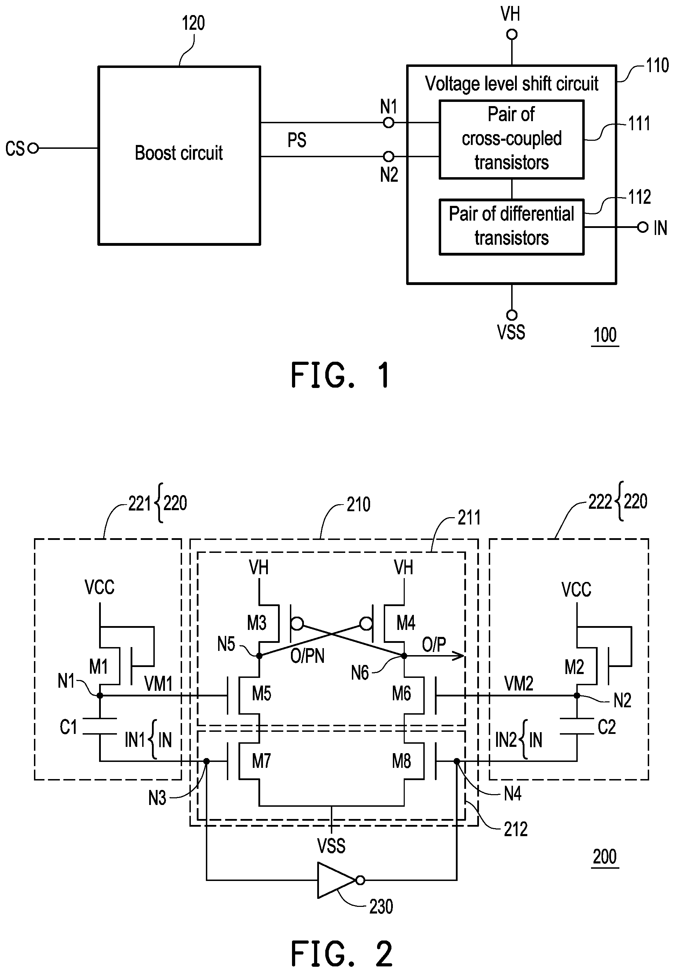

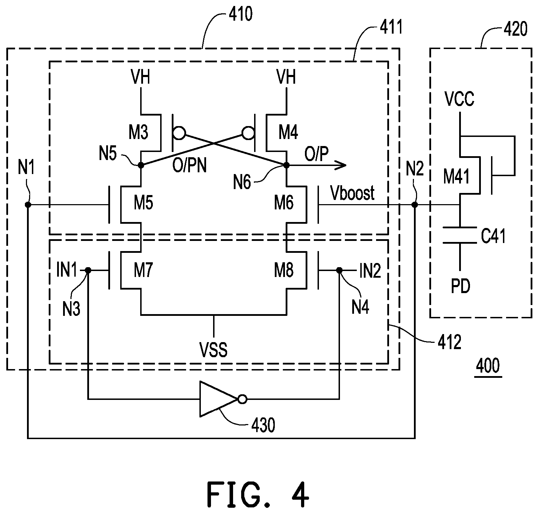

Refer to FIG. 1. A voltage level shifter 100 may be, for example, a voltage level shifter with a high voltage. The voltage level shifter 100 may be implemented in an application where a voltage value of a supply voltage is low (for example, below 1.8 volts) (for example, an energy-saving application). The supply voltage may be, for example, a supply voltage VCC shown in FIG. 2 or FIG. 4, wherein a voltage value of the supply voltage VCC may be, for example, 1.2 volts. The voltage level shifter 100 may, for example, have a circuit configuration of singleterminal output and differential input.

In the embodiment of FIG. 1, the voltage level shifter 100 includes a voltage level shift circuit 110 and a boost circuit 120. The voltage level shift circuit 110 is coupled to the boost circuit 120. The voltage level shift circuit 110 is configured to operate between a first voltage VH and a second voltage VSS, so as to perform a shift operation between the voltage value of the first voltage VH and the voltage value of the second voltage VSS. The first voltage VH may be, for example, a high supply voltage. The second voltage VSS may be, for example, a low supply voltage.

In the embodiment, the voltage level shift circuit 110 includes a pair of cross-coupled transistors 111 and a pair of differential transistors 112. The pair of cross-coupled transistors 111 is coupled to the pair of differential transistors 112. The pair of cross-coupled transistors 111 has multiple boost input terminals N1 to N2. The boost input terminals N1 to N2 are coupled to the boost circuit 120. The pair of differential transistors 112 receives a pair of input signals IN. The pair of input signals IN may be, for example, differential signals configured to drive the pair of differential transistors 112.

In the shift operation, the boost circuit 120 executes a pre-charging operation on the boost input terminals N1 to N2 of the pair of cross-coupled transistors 111. The boost circuit 120 also generates at least one voltage pulse PS based on a charge pump operation according to at least one control pulse signal CS. In other words, the boost circuit 120 is controlled by the control pulse signal CS to execute the charge pump operation to generate the voltage pulse PS corresponding to the control pulse signal CS. The boost circuit 120 provides the voltage pulse PS to the boost input terminals N1 to N2.

In the embodiment, the control pulse signal CS is generated corresponding to a transient edge of the pair of input signals IN. In other words, when the pair of input signals IN switches between different voltage levels and generates a rising edge or a falling edge, the control pulse signal CS is generated to drive the boost circuit 120 to execute the charge pump operation.

It is worth mentioning that the voltage level shifter 100 can increase the voltage values on the boost input terminals N1 to N2 by executing the pre-charging operation on the boost input terminals N1 to N2 through the boost circuit 120. Based on the increased voltage values, the pull-down ability of the pair of cross-coupled transistors 111 can be strengthened, thereby reducing voltage fighting. In addition, by providing the voltage pulse PS to the boost input terminals N1 to N2 based on the charge pump operation through the boost circuit 120, the voltage level shifter 100 can reduce voltage fighting and can also protect the pair of differential transistors 112 from damage by the first voltage VH. In this way, the voltage level shifter 100 can be implemented in the energy-saving application and can accelerate the speed of signal transition.

Refer to FIG. 2. A voltage level shifter 200 includes a voltage level shift circuit 210 and a boost circuit 220. The voltage level shift circuit 210 includes a pair of cross-coupled transistors 211 and a pair of differential transistors 212. The voltage level shift circuit 210 and the boost circuit 220 may be referenced and analogized from the relevant description of the voltage level shifter 100.

In the embodiment of FIG. 2, the boost circuit 220 includes a first boost block 221 and a second boost block 222. The first boost block 221 receives a supply voltage VCC. The first boost block 221 is coupled to a first boost input terminal N1 of the pair of cross-coupled transistors 211. The first boost block 221 is coupled to a first reference input terminal N3 of the pair of differential transistors 212. The first boost block 221 receives a first input signal IN1 on the first reference input terminal N3 to serve as a first control pulse signal (that is, the control pulse signal CS of the embodiment of FIG. 1).

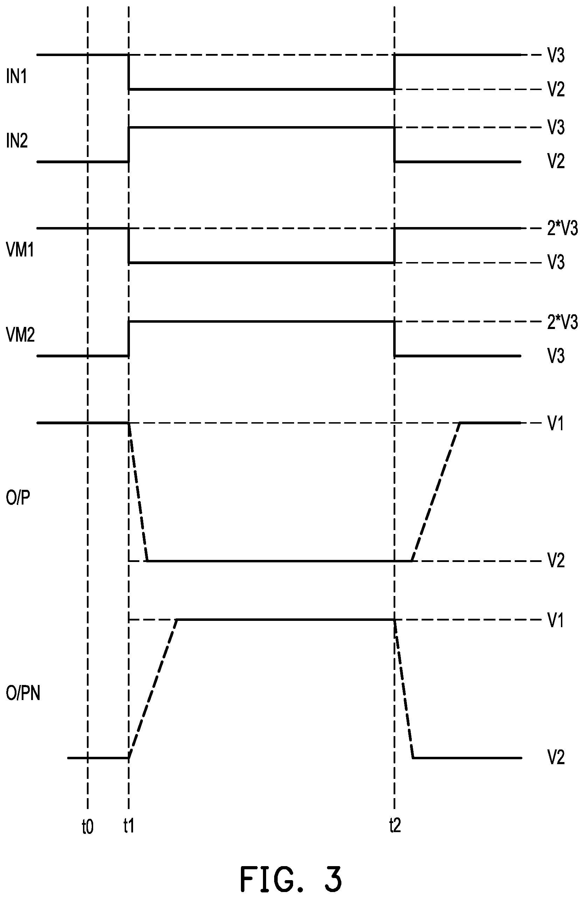

Specifically, the first boost circuit block 221 includes a transistor M1 and a capacitor C1. The transistor M1 may be, for example, implemented as an n-type metal-oxide-semiconductor field-effect transistor (NMOSFET). In the embodiment, the transistor M1 is a native transistor. In other words, a critical voltage value of the transistor M1 approaches zero. In other embodiments, the transistor M1 may also be a normal transistor, and the critical voltage value is less than the voltage value (for example, a third voltage value V3 shown in FIG. 3) of the supply voltage VCC.

In detail, a control terminal (that is, a gate terminal) and a first terminal (that is, a first source/drain terminal) of the transistor M1 are coupled together and receive the supply voltage VCC. In other words, the transistor M1 is in a diode-connected state. A second terminal (that is, a second source/drain terminal) of the transistor M1 is coupled to the first boost input terminal N1 and a first terminal of the capacitor C1. A second terminal of the capacitor C1 is coupled to the first reference input terminal N3.

In the embodiment, the second boost block 222 receives the supply voltage VCC. The second boost block 222 is coupled to a second boost input terminal N2 of the pair of cross-coupled transistors 211. The second boost block 222 is coupled to a second reference input terminal N4 of the pair of differential transistors 212. The second boost block 222 receives a second input signal IN2 on the second reference input terminal N4 to serve as a second control pulse signal (that is, the control pulse signal CS of the embodiment of FIG. 1).

Specifically, the second boost block 222 includes a transistor M2 and a capacitor C2. The transistor M2 may be, for example, implemented as an NMOSFET. In the embodiment, the transistor M2 is a native transistor and has a critical voltage value approaching zero. In other embodiments, the transistor M2 may also be a normal transistor, and the critical voltage value is less than the voltage value (for example, the third voltage value V3 shown in FIG. 3) of the supply voltage VCC. The transistors M1 and M2 are both taken as the native transistors in the following description.

In detail, a control terminal (that is, a gate terminal) and a first terminal (that is, a first source/drain terminal) of the transistor M2 are coupled together and receive the supply voltage VCC. In other words, the transistor M2 is in a diode-connected state. A second terminal (that is, a second source/drain terminal) of the transistor M2 is coupled to the second boost input terminal N2 and a first terminal of the capacitor C2. A second terminal of the capacitor C2 is coupled to the second reference input terminal N4.

In the embodiment, the pair of cross-coupled transistors 211 includes multiple transistors M3 to M6. The transistors M3 and M4 may be, for example, implemented as a p-type metal-oxide-semiconductor field-effect transistors (PMOSFET). The transistors M5 and M6 may be, for example, implemented as NMOSFET.

In detail, a first terminal (that is, a first source/drain terminal) of the transistor M3 receives a first voltage VH. A first terminal (that is, a first source/drain terminal) of the transistor M4 receives the first voltage VH. A control terminal (that is, a gate terminal) of the transistor M5 serves as the first boost input terminal N1. A first terminal (that is, a first source/drain terminal) of the transistor M5 is coupled to a second terminal (that is, a second source/drain terminal) of the transistor M3 and a control terminal (that is, a gate terminal) of the transistor M4 on a node N5. A second terminal (that is, a second source/drain terminal) of the transistor M5 is coupled to the pair of differential transistors 212.

Continuing with the above description, a control terminal (that is, a gate terminal) of the transistor M6 serves as the second boost input terminal N2. A first terminal (that is, a first source/drain terminal) of the transistor M6 is coupled to a second terminal (that is, a second source/drain terminal) of the transistor M4 and a control terminal (that is, a gate terminal) of the transistor M3 on a node N6. The node N6 serves as an output terminal of the voltage level shift circuit 210. A second terminal (that is, a second source/drain terminal) of the transistor M6 is coupled to the pair of differential transistors 212.

It should be noted that pull-down elements (that is, the transistors M5 and M6) of the pair of cross-coupled transistors 211 are inserted between pull-up elements (that is, the transistors M3 and M4) of the pair of cross-coupled transistors 211 and the pair of differential transistors 212 serving as pull-down elements. The transistors M5 and M6 may withstand the first voltage VH, and the critical voltage values thereof are higher than the transistors M7 and M8. If the supply voltage VCC is a low voltage (for example, 1.2V), the critical voltage values thereof are even substantially equal to the voltage value (for example, the third voltage value V3 shown in FIG. 3) of the supply voltage VCC.

In the embodiment, the pair of differential transistors 212 includes multiple transistors M7 and M8 with low voltage tolerance. It should be noted that multiple critical voltage values of the pair of differential transistors 212 are respectively less than the voltage value (for example, the third voltage value V3 shown in FIG. 3) of the supply voltage VCC. In other words, the critical voltage values of the transistors M7 and M8 are respectively less than the third voltage value.

Specifically, the pair of differential transistors 212 includes the transistors M7 and M8. The transistors M7 and M8 may be, for example, implemented as NMOSFET.

In detail, a control terminal (that is, a gate terminal) of the transistor M7 serves as the first reference input terminal N3 and receives the first input signal IN1. A first terminal (that is, a first source/drain terminal) of the transistor M7 is coupled to the second terminal (that is, the second source/drain terminal) of the transistor M5. A second terminal (that is, a second source/drain terminal) of the transistor M7 receives the second voltage VSS.

Continuing with the above description, a control terminal (that is, a gate terminal) of the transistor M8 serves as the second reference input terminal N4 and receives the second input signal IN2. A first terminal (that is, a first source/drain terminal) of the transistor M8 is coupled to the second terminal (that is, the second source/drain terminal) of the transistor M6. A second terminal (that is, a second source/drain terminal) of the transistor M8 receives the second voltage VSS.

In the embodiment, the voltage level shifter 200 also includes an inverter 230. A first terminal (that is, an input terminal) of the inverter 230 is coupled to the control terminal (that is, the first reference input terminal N3) of the transistor M7. A second terminal (that is, an output terminal) of the inverter 230 is coupled to the control terminal (that is, the second reference input terminal N4) of the transistor M8. In other words, the inverter 230 provides a pair of differential signals IN (that is, the first differential signal IN1 and the second differential signal IN2) with inversion on the first reference input terminal N3 and the second reference input terminal N4.

Refer to FIG. 2 and FIG. 3 at the same time. In FIG. 3, the horizontal axis is the operation time of the voltage level shifter 200, and the vertical axis is the voltage value. In the embodiment, the first voltage VH has a first voltage value V1. The second voltage VSS has a second voltage value V2. The supply voltage VCC has a third voltage value V3. The first voltage value V1 is greater than the third voltage value V3 and may be, for example, 10 volts (V). The third voltage value V3 is greater than the second voltage value V2 and may be, for example, 1.2 volts. The second voltage value V2 may be, for example, a reference ground voltage value.

In the embodiment, the boost circuit 220 executes a pre-charging operation according to the supply voltage VCC. In other words, during different periods corresponding to a shift operation, the boost circuit 220 respectively pre-charges the first boost input terminal N1 and the second boost input terminal N2 to the third voltage value V3 of the supply voltage VCC. The boost circuit 220 also operates based on a charge pump operation to respectively boost the first boost input terminal N1 and the second boost input terminal N2 to another voltage value. In this way, a voltage VM1 on the first boost input terminal N1 and a voltage VM2 on the second boost input terminal N2 are respectively switched between the third voltage value V3 and the other voltage value (for example, twice the third voltage value V3).

In the shift operation, the voltage level shifter 200, for example, switches an output voltage O/P from a high voltage value (that is, the first voltage value V1) to a low voltage value (that is, the second voltage value V2) at a time t1.

Specifically, before the time t1, the transistor M7 is conducted. The transistor M1 is conducted to execute the pre-charging operation on the first boost input terminal N1 according to the supply voltage VCC. Since the transistor M1 is a native transistor, the voltage VM1 on the first boost input terminal N1 is pre-charged to be equal to or substantially equal to the voltage value (that is, the third voltage value V3) of the supply voltage VCC. In addition, the transistor M1 and the capacitor C1 generate a voltage pulse (that is, the voltage VM1) corresponding to the first differential signal IN1 on the first boost input terminal N1 based on the charge pump operation according to the first differential signal IN1 serving as the control pulse signal. In other words, the voltage (that is, the first differential signal IN1 with the third voltage value V3) on the first reference input terminal N3 is provided to the first boost input terminal N1 through the capacitor C1, so that the voltage VM1 is equal to or substantially equal to twice the third voltage value V3.

Similarly, the voltage VM2 on the second boost input terminal N2 is pre-charged through the transistor M2 to be equal to or substantially equal to the voltage value (that is, the third voltage value V3) of the supply voltage VCC. In addition, since the second differential signal IN2 has the second voltage value V2 (that is, the reference ground voltage value), the voltage VM2 on the second boost input terminal N2 is maintained at the third voltage value V3.

At the time t1, the first differential signal IN1 switches from the third voltage value V3 to the second voltage value V2. The transistor M7 is controlled by the first differential signal IN1 and is disconnected. The second differential signal IN2 switches from the second voltage value V2 to the third voltage value V3. The transistor M8 is controlled by the second differential signal IN2 and is conducted. The transistor M2 and the capacitor C2 generate a voltage pulse corresponding to the second differential signal IN2 (that is, the voltage VM2) on the second boost input terminal N2 based on the charge pump operation according to the second differential signal IN2 serving as the control pulse signal, so that the voltage VM2 on the second boost input terminal N2 is pulled up to be equal to or substantially equal to twice the third voltage value V3.

At this time, the transistor M6 is controlled by the voltage VM2 and is conducted. The output voltage O/P on the node N6 is pulled down to the voltage value (that is, the second voltage value V2) of the second voltage VSS through the transistors M6 and M8. The transistor M3 is controlled by the output voltage O/P on the node N6 and is conducted, so that a voltage O/PN on the node N5 begins to be pulled up to the voltage value (that is, the first voltage value V1) of the first voltage VH. Until the voltage O/PN on the node N5 is pulled up to the voltage value (that is, the first voltage value V1) of the first voltage VH, the transistor M4 is disconnected to end a switching operation.

It should be noted that the voltage VM2 on the second boost input terminal N2 is pre-charged to the voltage value (that is, the third voltage value V3) of the supply voltage VCC through the transistor M2 and is then increased to twice the third voltage value V3 through the capacitor C2. Therefore, during the switching operation, the ability of pull-down elements (including the transistor M6) in the pair of cross-coupled transistors 211 being conducted is enhanced, thereby reducing voltage fighting.

In this way, the pull-down elements (including the transistor M6) in the pair of cross-coupled transistors 211 and pull-down elements (including the transistor M8) in the pair of differential transistors 212 can pull down the output voltage O/P easily and quickly to the second voltage value V2, thereby shortening the period during which the transistor M8 withstands the first voltage VH. Therefore, the voltage VM2 with twice the third voltage value V3 can protect the pair of differential transistors 212 from damage by the first voltage VH. In addition, the voltage O/PN on the node N5 can also be pulled up to the first voltage value V1 quickly, thereby accelerating the speed of signal transition.

An operation of the voltage level shifter 200 at a time t2 may be referenced and analogized from the relevant description of the voltage level shifter 200 at the time t1.

It should be noted that at the time t2, the voltage VM1 on the first boost input terminal N1 is pre-charged to the voltage value (that is, the third voltage value V3) of the supply voltage VCC through the transistor M1 and is then increased to twice the third voltage value V3 through the capacitor C1. Therefore, in the switching operation, the ability of the pull-down elements (including the transistor M5) in the pair of cross-coupled transistors 211 being conducted is enhanced, thereby reducing voltage fighting. Therefore, the pull-down elements (including the transistor M5) in the pair of cross-coupled transistors 211 and the pull-down elements (including the transistor M7) in the pair of differential transistors 212 can pull down the voltage O/PN easily and quickly to the second voltage value V2, so as to accelerate the speed of signal transition. In this way, the period during which the transistor M7 withstands the first voltage VH can be shortened, so as to prevent the pair of differential transistors 212 from being damaged by the first voltage VH.

Refer to FIG. 4. A voltage level shifter 400 includes a voltage level shift circuit 410 and a boost circuit 420. The voltage level shift circuit 410 includes a pair of cross-coupled transistors 411 and a pair of differential transistors 412. The voltage level shift circuit 410 and the boost circuit 420 may be referenced and analogized from the relevant description of the voltage level shifter 100.

In the embodiment of FIG. 4, the boost circuit 420 includes a transistor M41 and a capacitor C41. The transistor M41 may be, for example, implemented as an NMOSFET. In the embodiment, the transistor M41 is a native transistor and has a critical voltage value approaching zero.

In detail, a control terminal (that is, a gate terminal) and a first terminal (that is, a first source/drain terminal) of the transistor M41 are coupled together and receive a supply voltage VCC. In other words, the transistor M41 is in a diode-connected state. A second terminal (that is, a second source/drain terminal) of the transistor M41 is coupled to a first boost input terminal N1, a second boost input terminal N2, and a first terminal of the capacitor C41. A second terminal of the capacitor C41 receives a control pulse signal PD.

In the embodiment, the pair of cross-coupled transistors 411 includes multiple transistors M3 to M6. The pair of differential transistors 412 includes multiple transistors M7 and M8. The voltage level shifter 400 also includes an inverter 430. The transistors M3 to M6, the transistors M7 and M8, and the inverter 430 may be referenced and analogized from the relevant description of the voltage level shifter 200.

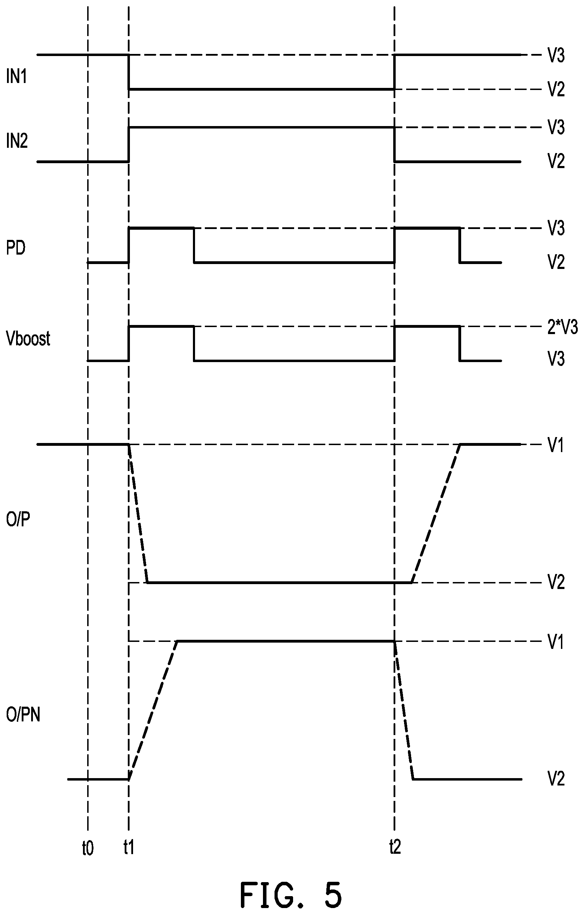

Refer to FIG. 4 and FIG. 5 at the same time. In FIG. 5, the horizontal axis is the operation time of the voltage level shifter 400, and the vertical axis is the voltage value.

Compared with the shift operations of FIG. 2 and FIG. 3, before a time t1, the transistor M41 is conducted to execute a pre-charging operation on the first boost input terminal N1 and the second boost input terminal N2 according to the supply voltage VCC. Since the transistor M41 is a native transistor, a voltage Vboost on the first boost input terminal N1 and the second boost input terminal N2 is pre-charged to be equal to or substantially equal to the voltage value (that is, the third voltage value V3) of the supply voltage VCC.

In addition, the transistor M41 and the capacitor C41 respectively generate a voltage pulse (that is, the voltage Vboost) corresponding to the control pulse signal PD on the first boost input terminal N1 and the second boost input terminal N2 based on a charge pump operation according to the control pulse signal PD. In other words, the control pulse signal PD with the second voltage value V2 (that is, the reference ground voltage value) is provided to the first boost input terminal N1 and the second boost input terminal N2 through the capacitor C41, so that the voltage Vboost is maintained at the third voltage value V3.

At the time t1, the first differential signal IN1 switches from the third voltage value V3 to the second voltage value V2. The transistor M7 is controlled by the first differential signal IN1 and is disconnected. The second differential signal IN2 switches from the second voltage value V2 to the third voltage value V3. The transistor M8 is controlled by the second differential signal IN2 and is conducted.

It should be noted that the control pulse signal PD is generated corresponding to a rising edge of the second differential signal IN2 (that is, a falling edge of the first differential signal IN1) to switch from the second voltage value V2 to the third voltage value V3. The transistor M41 and the capacitor C41 generate a voltage pulse (that is, the voltage Vboost) corresponding to the second differential signal IN2 on the first boost input terminal N1 and the second boost input terminal N2 based on the charge pump operation according to the control pulse signal PD, so that the voltage Vboost is pulled up to be equal to or substantially equal to twice the third voltage value V3.

At this time, the transistors M5 and M6 are controlled by the voltage Vboost and are conducted. The output voltage O/P on the node N6 is pulled down to the voltage value (that is, the second voltage value V2) of the second voltage VSS through the transistors M6 and M8. Then, the transistor M3 is conducted according to the output voltage O/P on the node N6, so that the voltage O/PN on the node N5 begins to be pulled up to the voltage value (that is, the first voltage value V1) of the first voltage VH. Until the voltage O/PN on the node N5 is pulled up to the voltage value (that is, the first voltage value V1) of the first voltage VH, the transistor M4 is disconnected to end the switching operation.

It should be noted that the voltage Vboost on the first boost input terminal N1 and the second boost input terminal N2 is pre-charged to the voltage value (that is, the third voltage value V3) of the supply voltage VCC through the transistor M41, and is then increased to twice the third voltage value V3 through the capacitor C41. Therefore, in the switching operation, a pull-down path (that is, a discharge path) between pull-down elements (including the transistor M6) in the pair of cross-coupled transistors 411 and pull-down elements (including the transistor M8) in the pair of differential transistors 412 and the second voltage value V2 is enhanced, thereby reducing voltage fighting.

In this way, the pull-down elements (including the transistor M6) in the pair of cross-coupled transistors 411 and the pull-down elements (including the transistor M8) in the pair of differential transistors 412 can pull down the output voltage O/P easily and quickly to the second voltage value V2, thereby shortening the period during which the transistor M8 withstands the first voltage VH. Therefore, the voltage Vboost with twice the third voltage value V3 can protect the pair of differential transistors 412 from damage by the first voltage VH. In addition, the voltage O/PN on the node N5 can also be pulled up to the first voltage value V1 quickly, so as to accelerate the speed of signal transition.

An operation of the voltage level shifter 400 at a time t2 may be referenced and analogized from the relevant description of the voltage level shifter 400 at the time t1.

In summary, the voltage level shifter of the embodiment of the disclosure may be applied in situations where the voltage value of the supply voltage is low. By executing the pre-charging operation on the boost input terminals through the boost circuit, and boosting the boost input terminals again based on the charge pump operation, the voltage level shifter can reduce voltage fighting, thereby accelerating the speed of signal transition, while protecting the pair of differential transistors from damage by the high supply voltage (that is, the first voltage).

Although the disclosure has been disclosed in the above embodiments, the embodiments are not intended to limit the disclosure. Persons skilled in the art may make some changes and modifications without departing from the spirit and scope of the disclosure. Therefore, the protection scope of the disclosure shall be defined by the appended claims.

## Claims

1. A voltage level shifter (100, 200, 400), comprising:
a voltage level shift circuit (110, 210, 410), operating between a first voltage (VH) and a second voltage (VSS), and comprising a pair of cross-coupled transistors (111, 211, 411) and a pair of differential transistors (112, 212, 412), wherein the pair of differential transistors (112, 212, 412) is coupled to the pair of cross-coupled transistors (111, 211, 411) and receives a pair of input signals; and
a boost circuit (120, 220, 420), coupled to the voltage level shift circuit (110, 210, 410) and configured to execute a pre-charging operation on a plurality of boost input terminals of the pair of cross-coupled transistors (111, 211, 411), generate at least one voltage pulse (PS) based on a charge pump operation according to at least one control pulse signal (CS, PD), and provide the at least one voltage pulse (PS) to the boost input terminals,
wherein the at least one control pulse signal (CS, PD) is generated corresponding to a transient edge of the pair of input signals.

2. The voltage level shifter (100, 200, 400) according to claim 1, wherein the boost circuit (120, 220, 420) executes the pre-charging operation according to a supply voltage (VCC), wherein the supply voltage (VCC) has a third voltage value (V3).

3. The voltage level shifter (100, 200, 400) according to claim 2, wherein a plurality of critical voltage values of the pair of differential transistors (112, 212, 412) are respectively less than the third voltage value (V3).

4. The voltage level shifter (100, 200, 400) according to claim 1, wherein the pair of differential transistors (112, 212, 412) comprises a plurality of transistors (M1~M8, M41) with low voltage tolerance.

5. The voltage level shifter (100, 200, 400) according to claim 1, wherein the boost circuit (120, 220, 420) comprises:
a first boost block (221), coupled to a first boost input terminal (N1) of the pair of cross-coupled transistors (111, 211, 411), and coupled to a first reference input terminal (N3) of the pair of differential transistors (112, 212, 412) to receive a first input signal (IN1) to serve as a first control pulse signal (CS, PD); and
a second boost block (222), coupled to a second boost input terminal (N2) of the pair of cross-coupled transistors (111, 211, 411), and coupled to a second reference input terminal (N4) of the pair of differential transistors (112, 212, 412) to receive a second input signal (IN2) to serve as a second control pulse signal (CS, PD).

6. The voltage level shifter (100, 200, 400) according to claim 5, wherein the first boost block (221) comprises:
a first transistor (M1~M8, M41), having a control terminal and a first terminal receiving a supply voltage (VCC); and
a first capacitor (C1~C2, C41), having a first terminal coupled to a second terminal of the first transistor (M1~M8, M41) and the first boost input terminal (N1), wherein a second terminal of the first capacitor (C1~C2, C41) is coupled to the first reference input terminal (N3).

7. The voltage level shifter (100, 200, 400) according to claim 6, wherein the first transistor (M1~M8, M41) is a native transistor.

8. The voltage level shifter (100, 200, 400) according to claim 6, wherein the second boost block (222) comprises:
a second transistor (M1~M8, M41), having a control terminal and a first terminal receiving the supply voltage (VCC); and
a second capacitor (C1~C2, C41), having a first terminal coupled to a second terminal of the second transistor (M1~M8, M41) and the second boost input terminal (N2), wherein a second terminal of the second capacitor (C1~C2, C41) is coupled to the second reference input terminal (N4).

9. The voltage level shifter (100, 200, 400) according to claim 8, wherein the second transistor (M1~M8, M41) is a native transistor.

10. The voltage level shifter (100, 200, 400) according to claim 1, wherein the boost circuit (120, 220, 420) comprises:
a first transistor (M1~M8, M41), having a control terminal and a first terminal receiving a supply voltage (VCC); and
a first capacitor (C1~C2, C41), having a first terminal coupled to a second terminal of the first transistor (M1~M8, M41), the first boost input terminal (N1), and the second boost input terminal (N2), wherein a second terminal of the second capacitor (C1~C2, C41) receives the at least one control pulse signal (CS, PD).

11. The voltage level shifter (100, 200, 400) according to claim 10, wherein the first transistor (M1~M8, M41) is a native transistor.

12. The voltage level shifter (100, 200, 400) according to claim 1, wherein the cross-coupled transistor (111, 211, 411) comprises:
a first transistor (M1~M8, M41), having a first terminal receiving the first voltage (VH);
a second transistor (M1~M8, M41), having a first terminal receiving the first voltage (VH);
a third transistor (M1~M8, M41), having a control terminal serving as a first boost input terminal (N1), wherein a first terminal of the third transistor (M1~M8, M41) is coupled to a second terminal of the first transistor (M1~M8, M41) and a control terminal of the second transistor (M1~M8, M41), and a second terminal of the third transistor (M1~M8, M41) is coupled to the pair of differential transistors (112, 212, 412); and
a fourth transistor (M1~M8, M41), having a control terminal serving as a second boost input terminal (N2), wherein a first terminal of the fourth transistor (M1~M8, M41) is coupled to a second terminal of the second transistor (M1~M8, M41) and a control terminal of the first transistor (M1~M8, M41), and a second terminal of the fourth transistor (M1~M8, M41) is coupled to the pair of differential transistors (112, 212, 412).

13. The voltage level shifter (100, 200, 400) according to claim 12, wherein the pair of differential transistors (112, 212, 412) comprises:
a fifth transistor (M1~M8, M41), having a control terminal receiving a first input signal (IN1), wherein a first terminal of the fifth transistor (M1~M8, M41) is coupled to a second terminal of the third transistor (M1~M8, M41), and a second terminal of the fifth transistor (M1~M8, M41) receives the second voltage (VSS); and
a sixth transistor (M1~M8, M41), having a control terminal receiving a second input signal (IN2), wherein a first terminal of the sixth transistor (M1~M8, M41) is coupled to a second terminal of the fourth transistor (M1~M8, M41), and a second terminal of the sixth transistor (M1~M8, M41) receives the second voltage (VSS).

14. The voltage level shifter (100, 200, 400) according to claim 13, further comprising:
an inverter (230, 430), having a first terminal coupled to a control terminal of the fifth transistor (M1~M8, M41), wherein a second terminal of the inverter (230, 430) is coupled to a control terminal of the sixth transistor (M1~M8, M41).
